# EUROPÄISCHE PATENTSCHRIFT

(11) **EP 0 617 140 B1**
(45) Veröffentlichungstag und Bekanntmachung des Hinweises auf die Patenterteilung: **29.09.1999**
(21) Anmeldenummer: 94200716.2
(22) Anmeldetag: 22.03.1994
(51) Int. Cl.: C23C 16/02, C23C 16/26

(54) **Hartmetallsubstrat mit Diamantschicht von hoher Haftfestigkeit**
Substrate body of hard alloy with diamond coating of excellent adhesive strength
Substrat en métal dur avec une couche de diamant d'excellente solidité de fixation

(30) Priorität: 26.03.1993 AT 61293
(43) Veröffentlichungstag der Anmeldung: 28.09.1994
(73) Patentinhaber: PLANSEE TIZIT GESELLSCHAFT M.B.H., 6600 Reutte/Tirol (AT)
(72) Erfinder: Feistritzer, Stefan, Dipl.-Ing., A-6600 Reutte (AT); Schintlmeister, Wilfried, Dr., A-6600 Reutte (AT); Kanz, Johann, A-6600 Reutte (AT)
(74) Vertreter: Lohnert, Wolfgang, Dr.

(56) Entgegenhaltungen:
- EP-A- 0 374 923
- EP-A- 0 464 012
- EP-A- 0 500 119

## Beschreibung

Die Erfindung betrifft ein Verfahren zur Haftverbesserung zwischen einem aus Hartstoff und Bindemetall aufgebauten Hartmetall-Substrat und einer darauf aufgetragenen, aus der Gasphase abgeschiedenen Diamantschicht durch ein der Schichtauftragung vorausgehendes Entfernen von Bindemtall von der Hartmetall-Oberfläche.
Die Erfindung betrifft insbesondere ein Verfahren, bei dem nacheinander in der gleichen Vorrichtung das Entfernen von Bindemetall von der Oberfläche und das Aufbringen von Diamantschichten auf Hartmetall-Substraten nach dem Heißdraht (hot filament)-Beschichtungsverfahren erfolgt.

Die Entwicklung von Diamantbeschichtungen mittels CVD (chemical vapor deposition)-Verfahren auf Substratmaterialien in Einbeziehung einer Wasserstoff-Dissoziierung hat zu unterschiedlichen Beschichtungstechnologien und Bereitstellung entsprechender Vorrichtungen geführt. Unter den verschiedenen Techniken seien vorzugsweise die Beschichtung nach dem Heißdraht(hot filament bzw. HF-CVD)-Verfahren, nach dem Mikrowellen-Verfahren und nach dem Jet-Verfahren in Einbeziehung eines Plasmastrahles stellvertretend genannt.
Die verschiedenen gebräuchlichen Verfahren und ihre grundsätzliche Wirkungsweise sind in einem Übersichtsartikel von B. Lux und R. Haubner in den Proceedings des 12. Internationalen PLANSEE-Seminars 1989, Volume 3, Seiten 615ff, Herausgeber H. Bildstein und H. Ortner, zusammengefaßt worden. Der Übersichtsaufsatz greift auf 150 Fachaufsätze zurück, sodaß an dieser Stelle auf eine nähere Beschreibung der gebräuchlichen Techniken verzichtet werden kann.

Unter den verschiedenartigen Anwendungsmöglichkeiten läßt die Auftragung von verschleißmindernden Diamantschichten auf Hartmetall-Schneid- bzw. -Zerspanungseinsätzen einen hohen technologischen Nutzen erwarten und hat bereits einen hohen Entwicklungsstand erreicht.

Ein wesentliches, dabei bis heute nur unzureichend gelöstes Problem betrifft die ausreichende Haftung der Diamantschicht auf der Substrat-Oberfläche.

Es wurde bereits erkannt, daß in einem aus Hartstoff-Komponenten und Bindemetall bestehenden Hartmetall das Bindemetall in einer oberflächennahen Randzone des Substrats für die schlechten Haftungseigenschaften ursächlich ist. Es überrascht daher nicht, daß bereits eine Vielzahl von Verfahren vorgeschlagen wurden, um den störenden Einfluß des Bindemetalls an der Oberfläche zu reduzieren.

Die EP 0 384 011 A1 gibt zum Stand der Technik eine Übersicht über Maßnahmen, die bisher zur Steigerung der Haftungsfestigkeit zwischen einem Substrat-Werkstoff, insbesondere Hartmetall, und einer auf diesem abgeschiedenen Diamantschicht vorgeschlagen wurden.
Eine erste Technik betrifft die Auftragung einer Zwischenschicht zwischen Hartmetall und Diamantschicht, die keines der Bindermetalle Eisen, Kobalt und/oder Nickel enthält. Doch die aus praktischer Sicht nur in beschränkter Dicke anbringbare Zwischenschicht stellt keine ausreichende Barriere gegen eine Wanderung des Binders zur Beschichtungsoberfläche dar. Wenn, wie vorgeschlagen, eine Wolfram und Kohlenstoff, z. B. W₂C-enthaltende Zwischenschicht eingebracht wird, kommt erschwerend hinzu, daß zusätzlich unterschiedliche Vorrichtungen für die Abscheidung der Zwischenschicht und die Abscheidung der Diamantschicht erforderlich sind.

Nach einer anderen Verfahrensvariante wird durch die Aufbringung einer Wolfram-Zwischenschicht auf einen Hartmetall-Schneideinsatz für die Zerspanung zwar das Haftungsproblem wesentlich verbessert, da das W bei der anschließenden Diamantbeschichtung zumindest teilweise zu WC umgewandelt wird, stellt die Zwischenschicht keine ausreichende Diffusionsbarriere dar.

Nach einem weiteren vorbeschriebenen Verfahren wird in einer Kobalt als Bindemetall aufweisenden Hartmetall-Phase das Kobalt von der Hartmetall-Oberfläche mittels einer Säurebehandlung abgeätzt. Die Abätzung läßt sich indes nicht auf eine oberflächennahe Randzone beschränken, sodaß dort tiefreichende Poren entstehen. Eine tiefe Co-verarmte Randzone führt zu nicht tolerierbarer Sprödigkeit in der Randzone. Die Rauhigkeit und Struktur der Oberfläche sind für die nachfolgende Beschichtung ungünstig. Das erniedrigt die Haftung der nachfolgenden Diamantschicht stark.

Nach einem letzten dort genannten Verfahren wird die Hartmetall-Oberfläche vor dem Beschichtungsvorgang abgeschliffen. Gleichwohl bleiben Oberflächenbereiche aus Bindemetall bestehen, an denen sich beim anschließenden Beschichtungsprozeß nach wie vor eine Graphitphase anstelle einer Diamantphase bildet. Die Graphitbildung ist aber eine Hauptursache für schlechte Haftung zwischen Substrat und Diamantschicht.

Das in der EP 0 384 011 A1 geschützte Verfahren schließt an diesen Stand der Technik unmittelbar an. Es folgt dort nach dem Schleifprozeß eine Dekarburierung der Wolframkarbid-Kobalt Substrat-Oberfläche unter Rekristallisierung von Wolframkarbid. Die Dekarburierung erfolgt mittels Zuführung von Sauerstoffgas an die Substrat-Oberfläche und geht gleichzeitig einher mit der Entfernung von Metall, insbesondere auch Bindemetall aus der Oberfläche, vorzugsweise als flüchtiges Oxid. Ein Nachteil dieses Verfahrens besteht in der Gefahr, daß der eingeleitete Sauerstoff in Teilbereichen des Substrats zu bleibenden, unerwünschten Oxidbildungen führt. Durch das Schleifen der Substrat-Oberfläche werden dort zwangsläufig Verunreinigungen angelagert, die während des anschließenden Dekarburierungsprozesses nicht vollständig entfernbar sind, ohne gleichzeitig die Oberflächenstruktur bzw. Oberflächenrauhigkeit im Hinblick auf guthaftende Diamantschichten nachhaltig zu verschlechtern.

Ein wesentlicher Nachteil dieses Verfahrens besteht schließlich in der Erfordernis geeigneter Anlagen neben den Anlagen für die CVD-Diamantbeschichtung. So würden die in Heißdraht-Anlagen üblicherweise verwendeten Ta- oder W-Filamente durch die Sauerstoff-Behandlung unbrauchbar.

Aus dem Dokument EP-A-0 464 012 ist die Entfernung der Binderphase im Oberflächenbereich eines Karbid-Hartmetall Körpers durch Wärmebehandlung unter leicht dekarburienden Bedingungen oder im Vakuum bekannt.

Aufgabe vorliegender Erfindung ist es, die Haftverbesserung zwischen einem Hartmetall-Substrat und einer auf ihm aufgetragenen Diamantschicht nachhaltig zu verbessern, ohne die zuvor geschilderten Nachteile bei Anwendung der bekannten Verfahren in Kauf zu nehmen. Die zu erreichende Haftungsgüte ist insbesondere im Hinblick auf die Verwendung derartig beschichteter Produkte als Schneideinsatz bzw. als Zerspanungswerkzeug zu sehen, bei dem wegen starker lokaler thermischer und mechanischer Beanspruchungen diesbezüglich besonders hohe Anforderungen gestellt sind.

Die erfinderische Aufgabe wird gelöst durch ein Verfahren gemäß Anspruch 1 dieses Patentes. Vorteilhalfe Ausführungsformen des Verfahrens werden in den Ansprüchen 2 bis 9 beansprucht.

Hartmetall-Substrate nach dieser Erfindung sind Karbid- bzw. Mischkarbid-Hartmetalle unter Verwendung von Metallen der Gruppe IVa - VIa des Periodensystems, aber auch solche, bei denen der Hartstoff ganz oder teilweise aus Karbonitrid- und/oder Nitridwerkstoffen besteht, z.B. Cermets. Technisch bedeutsame Bindemetalle sind Kobalt und Nickel, aber auch Legierungen derselben, sowie Zusätze wie Eisen und Chrom. Die Bindemetall-Anteile am Hartmetall liegen üblicherweise zwischen 4 und 30 Gew.%. Entsprechend einer bevorzugten Verwendung derartiger beschichteter Produkte als Schneid-bzw. Zerspanungseinsatz, umfaßt der Begriff alle Hartstoff/Bindemetall-Kombinationen, die für derartige Anwendungen benutzt werden.

Der Begriff Gasphasen-Reaktion umfaßt die CVD-Technologie (Chemical Vapor Deposition), im Unterschied z.B. zu den PVD-Verfahren (Physical Vapor Deposition), wie dem Ionensputtern des Schichtwerkstoffes von einer festen Verdampferquelle.

Unter den vielen eingangs angeführten Vorrichtungen und Verfahren für eine CVD-Diamantbeschichtung besitzt das Heißdraht (hot filament)-Verfahren dank seiner vergleichsweise großen Beschichtungsfläche derzeit eine herausragende Bedeutung - und damit auch für die Bindemetall-Entfernung gemäß vorliegender Erfindung.
Entsprechend betrifft eine Mehrzahl der Unteransprüche besondere Ausgestaltungen der Erfindung in Anwendung der Hotfilament-Technik.

Es ist gleichermaßen denkbar, das erfinderische Verfahren und auch das Entfernen des Bindemetalls in einer einzigen Vorrichtung durchzuführen, wie auch die Verwendung unterschiedlicher Verfahren und Vorrichtungen, zum einen für das erfindungsgemäße Entfernen des Bindemetalls, zum anderen für das nachfolgende Auftragen einer Diamantschicht selbst. Dabei bietet sich an, das Entfernen des Bindemetalls und die anschließende Diamantbeschichtung fortlaufend in ein und derselben Beschichtungsanlage in zwei unmittelbar aufeinanderfolgenden Prozeßschritten durchzuführen. Es kann aber auch notwendig sein, die Prozesse des Bindemittel-Entfernens und der Diamantbeschichtung, obwohl in ein und derselben Vorrichtung durchgeführt, zu trennen und das Substrat vorübergehend aus der Vorrichtung auszubauen, und zwar dann, wenn das von der Bindemetallphase in oberflächennahen Randzonen befreite Hartmetall vor der Auftragung der Diamantschicht einer weiteren Vorbehandlung unterzogen wird, wie z. B. das Kratzen mit Diamantkorn.

Es ist gemäß kennzeichnendem Teil von Anspruch 1 erfindungswesentlich, sicherzustellen, daß die Abdampfung des Bindemetalls nur aus einer schmalen oberflächennahen Randzone erfolgt, dort aber weitgehend vollständig. Die Bindemetall-Abdampfung erfolgt in Form des reinen Metalls, aber möglicherweise auch in Form von metastabilen Metallhydriden.

Da ursprünglich eine feste räumliche Struktur von Karbid- und Bindemetall-Anteilen in der Hartmetallphase festliegt, ist die vollständige Freisetzung der Oberfläche von Bindemetall mit einer Strukturänderung in Form einer Hartstoff-Rekristallisation im Oberflächenbereich verbunden. Die Rekristallisation der Hartstoff-, insbesondere der Karbid-Anteile, läuft einerseits über ein Lösen in einer Wolfram/Kohlenstoff-Bindemetall-Phase und die Wiederausscheidung von Hartstoff; insbesondere Karbiden aus der vorgenannten Mischphase, andererseits durch Rekristallisation des Hartstoffkorns an sich aufgrund der hohen Oberflächentemperatur ab. Gleichzeitig bildet sich eine geschlossene, aufgerauhte Hartstoff-Oberflächenstruktur. Die WC-Körner an der Oberfläche besitzen ungefähr die gleiche Korngröße wie das übrige Hartmetall-Gefüge. Die mittlere Oberflächenrauhigkeit beträgt dann ca. die Hälfte, oder auch weniger, des mittleren Korndurchmessers. Die Vorgänge der Bindermetall-Abdampfung dürfen sich ausschließlich in einer Oberflächen-Randzone von maximal wenigen Mikrometern Stärke abspielen. Das übrige Volumen des Hartmetall-Substrates muß während dieses Verfahrens auf so niedriger Temperatur gehalten werden, daß nennenswerte Material-Wanderungen und Werkstoff-Veränderungen dort unterbleiben.

Eisen, Kobalt, Nickel sind die vorzugsweise in Hartmetallphasen verwendeten Bindemetalle. Die Verdampfungspunkte dieser Metalle liegen bei ca. 3000°C. Diffusions- und Phasenänderungen in Hartmetallen sind aber ab Temperaturen von 900° und höher nicht mehr vernachlässigbar. Unter Berücksichtigung der in Hartmetallen gegebenen guten Wärmeleitfähigkeit lassen sich derartig extrem unterschiedliche Temperaturzustände an der Oberfläche und im Substratinneren nur unter Einbeziehung des Wasserstoffs und dessen Reaktionskette erreichen. In Anlagen zur CVD-Diamantbeschichtung wird bekanntlich der zugeführte Wasserstoff je nach angewendeter Technik und Vorrichtung entweder an den heißen Drähten oder im Mikrowellenplasma oder auch im Bereich des Plasmabogens dissoziiert und in unmittelbarer zeitlicher und räumlicher Nachbarschaft hierzu an der Oberfläche des Substrates über eine stark exotherme Reaktion wieder zu H₂-Molekülen rekombiniert. Es war nun überraschend und nicht vorhersehbar, daß die Prozeßwärme des exothermen Prozesses an der Substrat-Oberfläche ausreicht, um lokal Bindephasen-Metalle zur Abdampfung und die Hartstoffphase zur Rekristallisation zu bringen - ggf. unter Hydridbildung. Die durchschnittliche makroskopische Oberflächentemperatur liegt indes weit unter der Bindemetall-Verdampfungstemperatur, sodaß die Bindemetall-Freisetzung sich auf eine sehr oberflächennahe Randzone des Substrates beschränkt, in deren unmittelbarer Nachbarschaft die exotherme H₂-Rekombination in ausreichender Reaktionsdichte stattfindet. Damit ist erklärbar, daß sich die Zustandsbedingungen innerhalb einer nur im µ-Bereich liegenden Zone in Richtung Substratinneres so verändern, daß dort keinerlei Materialreaktionen mehr stattfinden.

Zur Erreichung möglichst optimaler Haftverbesserungs-Bedingungen auf der Substrat-Oberfläche spielt das Verhältnis von Wasserstoff zu kohlenstoffhaltigen Gasen, wahlweise vermischt mit Edelgas, eine bedeutende Rolle. Es kann auf die Beimischung von kohlenstoffhaltigen Gasen zum Reaktionsgas nicht vollständig verzichtet werden, weil andernfalls eine Unterkohlung, wie z. B. die Bildung der gefürchteten Eta-Phase im Hartmetall stattfindet. Ist die Konzentration des kohlenstoffhaltigen Gases in der gesamten Atmosphäre aber zu hoch, so kommt es zur vorzeitigen Abscheidung von Graphit oder auch Diamant auf der Substrat-Oberfläche, was aber in diesem Prozeßstadium grundsätzlich zu vermeiden ist.

Der Prozeß des Abdampfens von Bindemetall von der Substrat-Oberfläche findet in erster Näherung unter den Bedingungen statt, wie diese für die Diamantbeschichtung nach dem CVD-Verfahren bekannt sind.
Der Gesamtdruck p der Gasatmosphäre im Reaktionsraum liegt zwischen 0,1 und 25 kPa. Im Unterschied zu den Verhältnissen für die Diamantbeschichtung darf das Volumverhältnis von H₂ zu Kohlenwasserstoff enthaltendem Gas nur zwischen etwa 10² und 10³ variieren.

Die Vorbehandlungsdauer t für das oberflächliche Entfernen des Bindemetalls liegt vorteilhafterweise zwischen 0,5 und 6 Stunden.

Bei Anwendung der Heißdraht-Technik und einer entsprechenden Vorrichtung sind die Temperatur T des Heizleiters selbst sowie der Abstand zwischen Substrat-Oberfläche und Heizleiter D gegenüber den Prozeßbedingungen für die übliche Diamantbeschichtung zu verändern. Während die Diamantbeschichtung bei Heizleiter-Temperaturen von ca. 2000°C abläuft, muß die Heizdraht-Temperatur für den erfindungsgemäßen Prozeß auf 2100°C und höher gebracht werden. Gleichzeitig muß der Abstand D zwischen Substrat-Oberfläche und Heizdraht gegenüber demjenigen bei der Diamantbeschichtung verkleinert werden, vorteilhafterweise auf Werte zwischen 2 und 10 mm.

Soweit das Entfernen des Kobalts von der Substrat-Oberfläche nach dem Heißdraht-Verfahren erfolgt, gelten vorteilhafterweise folgende Verfahrensparameter:
Filamenttemperatur T = 2250 - 2300°C
Abstand Substrat-Quelle für dissoziierten Wasserstoff D = 2,5 - 3 mm
Gesamtgasdruck im Reaktionsraum p = 1,3 - 2 kPa
Behandlungsdauer t = 2,5 - 3 h

Das Verfahren gemäß vorliegender Erfindung führt zu einer wesentlichen Steigerung der Haftfestigkeit zwischen Hartmetall-Substrat und Diamantschicht.
Der Vorbehandlungsprozeß ist besonders wirtschaftlich und belastet die gesamten Herstellungskosten für ein diamantbeschichtetes Produkt unbedeutend, wenn ein und dieselbe Vorrichtung für die erfindungsgemäße Vorbehandlung und die anschließende Diamantbeschichtung Verwendung findet.

Die verbesserte Haftung von Diamantschichten auf Hartmetall-Schneideinsätzen wird im Rahmen der nachfolgenden Beispiele in Zerspanungsversuchen quantifiziert und mit Produkten, hergestellt nach bekannten Verfahren, verglichen.

Die Erfindung wird nachfolgend anhand einiger Beispiele näher erläutert.

### BEISPIEL 1

Als Substrate werden Hartmetall-Wendeschneidplatten der Geometrie SPEW 120408 aus einer K10-Hartmetallsorte (94 % WC + 6 % Co, mittlere Korngröße ∼1µ) verwendet. Die erfindungsgemäße Substrat-Vorbehandlung erfolgt in einer Einrichtung zur Diamantbeschichtung nach dem Heißdraht-CVD-Verfahren. Diese Substrate werden auf einem ebenen Substrathalter fixiert und auf einen Abstand von 3 mm +- 1 mm zwischen Filamente und zu beschichtende Wendeschneidplatten-Oberfläche gebracht.

Vorbehandlung mit folgenden Bedingungen:
T_{FIL} = 2250°C
T_{SUB} = 900°C (im Substratinneren gemessen)
- Gasphase:: 0,5 % CH₄ (Rest H₂), 1,3 kPa
- Zeitdauer:: 10 min Aufheizen
2 h Co-Verdampfen
10 min Abkühlen

Die anschließende metallographische Untersuchung des Substrates im Rasterelektronenmikroskop bestätigte die Entfernung des Co von der Substratoberfläche bei gleichzeitiger Oberflächenaufrauhung.
Um eine quantitative Aussage zur dadurch erreichten Haftverbesserung zu erhalten, wurden nach diesem Verfahren vorbehandelte und dann beschichtete Wendeplatten mit anderen verglichen, die zum einen nicht, zum anderen nach der herkömmlichen Ätzmethode vorbehandelt worden waren (3 bzw. 5 min in in kochender, 10%iger Salzsäure). Solcherart vorbehandelte Wendeschneidplatten wurden anschließend mit einer ca. 8µ starken Diamantschicht nach dem Hot-Filament-CVD-Verfahren versehen.
Die Proben wurden danach sowohl einem Rockwell-Haftungstest wie auch einem Zerspanungstest (Drehen von Gußaluminium-SiliziumLegierung GAlSi 13 und GAlSi 20) unterzogen. Die Versuchsbedingungen für den Test mit Rockwell-Eindruck lauteten: Last 62,5 kg; Prüfspitze:
Radius 0,2 mm, Kegelwinkel 120°.
Die Zerspanungsbedingungen lauteten:
- für GAlSi 13:: Schnittgeschwindigkeit (V_{c}) = 500 m/min Vorschub (f) = 0,1 mm/U
Schnittiefe (aₚ) = 1 mm (mit Kühlung)
- für GAlSi 20:: V_{c} = 300 m/min; f = 0,1 mm/U; aₚ = 1,5 mm

Die Tests zeigten eine weit bessere Schicht-Haftfestigkeit für Wendeplatten, die vor der Diamantbeschichtung dem Co-Verdampfungsprozeß unterzogen worden waren als die für solche, die nicht oder nach herkömmlicher Methode säurebehandelt worden waren.
Tabelle 1 zeigt die wesentlichen Testergebnisse.

### BEISPIEL 2

In diesem Fall wurden SPEW 120408 Wendeschneidplatten entsprechend Beispiel 1 mit dem Mikrowellen-CVD-Verfahren, wie eingangs zum Stand der Technik zitiert, vorbehandelt. Die geringe Ausbeute an atomarem Wasserstoff erlaubte die Vorbehandlung von jeweils nur einer einzelnen Probe. Die Wendeplatte wurde derartig in das kugelförmige Plasma eingetaucht, daß auch die Freiflächen ganz dem Plasma ausgesetzt waren. Das Substrat wurde weder zusätzlich geheizt noch gekühlt. Es lag am ungekühlten Substrathalter an. Prozeßbedingungen:
Mikrowellenleistung = 1500 W
T_{SUB} = 500°C (im Substratinneren gemessen)
- Gasphase:: 0,5 % CH₄ (Rest H₂), 3,9 kPa
- Zeitdauer:: 6 h

Die Substrate zeigten die gleiche Aufrauhung der Oberfläche durch WC-Rekristallisation, wie sie auch bei der Co-Verdampfung mit Hot-Filament-CVD-Technik auftritt. Auch die Haftungseigenschaften waren mit denen, dargestellt in Beispiel 1, vergleichbar.

### BEISPIEL 3

Die erfindungswesentliche Co-Verdampfung wird mittels des Plasma-Jet-Verfahrens durchgeführt. Hierbei strömt ein H₂/Kohlenwasserstoff-Gasgemisch zwischen den Elektroden des Glühbogens hindurch. Das Gas wird dabei auf eine für Wasserstoff-Dissoziation notwendige Temperatur aufgeheizt. Die hohe Gastemperatur erfordert eine Kühlung des Substrates bzw. des Substrathalters mit Wasser.
Prozeßbedingungen:
Bogenstrom = 30 A
Elektrodenspannung = 100 V
T_{SUB} = 850°C (im Substratinneren gemessen)
- Gasphase:: 0,5 % CH₄, Rest H₂, 2 kPa
- Zeitdauer:: 1 h

Wie schon in den Beispielen 1 und 2 konnte auch hier eine Co-Verdampfung von der Hartmetall-Oberfläche mit gleichzeitigem Auftreten einer Oberflächenaufrauhung erreicht werden. Die Haftung von Diamantschichten auf mit dem Plasma-Jet-vorbehandelten Hartmetall-Wendeschneidplatten entspricht in etwa den für Proben Nr. 1 und 2 in Tabelle 1 ausgewiesenen Werten.

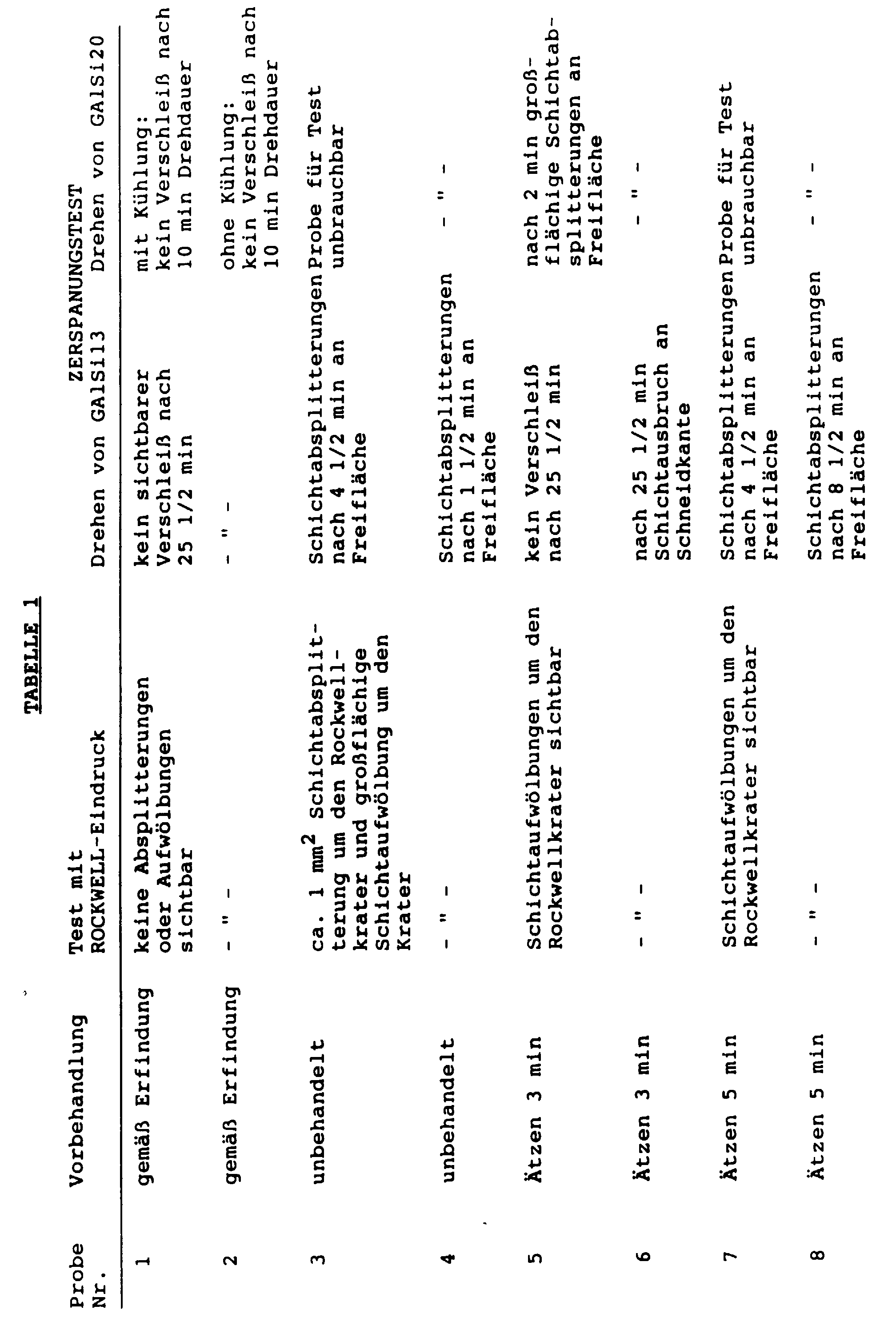

## Patentansprüche

1. Verfahren zur Haftverbesserung zwischen einem aus Hartstoff und Bindemetall aufgebauten Hartmetallsubstrat für Schneidplatten und einer darauf aufgetragenen, mittels Heißdraht-Chemisches Dampfabscheidungs (HF-CVD)-Verfahren aus der Gasphase abgeschiedenen Diamantschicht, durch ein der Schichtauftragung vorausgehendes Entfernen von Bindemetall mittels Wärmebehandlung, wobei ein Umstrukturieren und Aufrauhen der Hartmetalloberfläche erfolgt,
**dadurch gekennzeichnet,**
- daß für das Entfernen des Bindemetalls Vorrichtungen verwendet werden, wie sie aufgrund der Verfügbarkeit von kohlenstoffhaltigen Gasen und am Heißdraht dissoziierendem Wasserstoff für das HF-CVD-Verfahren geeignet sind,
- daß im Unterschied zu den Bedingungen für die Abscheidung einer Diamantschicht für die Bindemetall-Entfernung das Verhältnis von H₂-Gas zu Kohlenwasserstoff-Gas im Reaktionsraum der Vorrichtung auf einen Wert 10² - 10³ verändert und gleichzeitig die Glühtemperatur T der Heißdrahtelementeauf einen Wert > 2100°C gebracht werden,
- daß an der Substratoberfläche über die Anwesenheit dissoziierten Wasserstoffs Zustandsbedingungen geschaffen werden, bei denen über eine stark exotherme Reaktion dissoziierter Wasserstoff zu H₂ rekombiniert und ein wärmebedingtes Abdampfen von Bindemetall aus einer oberflächennahen Randzone des Substrates erfolgt,
- daß das Substratinnere auf Temperaturen unterhalb einer Obergrenze eingestellt wird, ab der sich im Inneren eine auf die bestimmungsgemäße Verwendung des diamantbeschichteten Substrats auswirkende Materialänderung eintritt.

2. Verfahren nach Anspruch 1, dadurch gekennzeichnet, daß im Unterschied zu den Bedingungen für die Abscheidung einer Diamantschicht für die Bindemetall-Abdampfung die zu beschichtende Substratoberfläche auf einen kleineren Abstand D zur Ebene der Heißdrahtelemente gebracht wird.

3. Verfahren nach Anspruch 1 bis 2, dadurch gekennzeichnet, daß das Gas in dem Reaktionsraum unter einem Gesamtdruck p von 0,1 - 25 kPa zugeführt wird.

4. Verfahren nach einem der Ansprüche 1 bis 3, dadurch gekennzeichnet, daß das Prozeßgas unter einem Gesamtdruck p von 0,1 - 25 kPa zugeführt wird.

5. Verfahren nach einem der Ansprüche 1 bis 4, dadurch gekennzeichnet, daß das Entfernen des Bindemetalles innerhalb einer Prozeßdauer t von 0,5 bis 6 h erfolgt.

6. Verfahren nach Anspruch 1 bis 5, dadurch gekennzeichnet, daß zum Entfernen des Bindemetalles folgende Prozeßparameter angewandt werden, T = 2250 - 2300°C, D = 2,5 - 3 mm, p = 1,3 - 2,0 kPa, t = 2,5 - 3 h.

7. Verfahren nach Anspruch 1 bis 6, dadurch gekennzeichnet, daß die Substrate zu beiden Seiten von in vertikaler Ebene angeordneten Heißdraht-Elementen angeordnet sind.

8. Verfahren nach Anspruch 1 bis 7, dadurch gekennzeichnet, daß das Bindemetall in Form metastabiler Hydride abgedampft wird.

9. Verfahren nach Anspruch 1 bis 8, dadurch gekennzeichnet, daß WC-Co-Hartmetall als Substrat verwendet wird.

## Claims

1. Process for improving adhesion between a hard alloy substrate composed of hard material and binding metal for indexable inserts and a diamond coating applied thereto by means of hot filament chemical vapour deposition (HF-CVD) process and deposited from the gas phase, by a removal prior to coating application of binding metal by means of heat treatment, wherein restructuring and roughening of the hard alloy surface takes place, characterised
- in that for removal of the binding metal, apparatuses are used such as are suitable for the HF-CVD process due to the availability of carbon-containing gases and hydrogen dissociating at the hot filament,
- in that, unlike the conditions for the depositing of a diamond coating for the removal of binding metal, the ratio of H₂ gas to hydrocarbon gas in the reaction chamber of the apparatus changes to a value of 10² - 10³ and simultaneously the glow temperature T of the hot filament element is brought to a value of >2100°C,
- in that at the substrate surface, via the presence of dissociated hydrogen, conditions are created in which, via a strongly exothermic reaction, dissociated hydrogen is recombined to H₂ and vaporisation by heat of binding metal from a peripheral zone of the substrate close to the surface is effected,
- in that the substrate interior is set to temperatures below an upper limit, from which in the interior a material change arises which affects the use according to stipulation of the diamond-coated substrate.

2. Process according to claim 1, characterised in that unlike the conditions for the depositing of a diamond coating, for the binding metal vaporisation the substrate surface to be coated is brought to a smaller distance D from the plane of the hot filament elements.

3. Process according to claim 1 to 2, characterised in that the gas in the reaction chamber is supplied at an overall pressure p of 0.1 - 25 kPa.

4. Process according to one of claims 1 to 3, characterised in that the process gas is supplied at an overall pressure p of 0.1 - 25 kPa.

5. Process according to one of claims 1 to 4, characterised in that the removal of the binding metal is effected within a process duration t of 0.5 to 6 h.

6. Process according to claim 1 to 5, characterised in that for the removal of the binding metal the following process parameters are applied: T = 2250 - 2300°C, D = 2.5 - 3 mm, p = 1.3 - 2.0 kPa, t = 2.5 - 3 h.

7. Process according to claim 1 to 6, characterised in that the substrates are disposed on either side of hot filament elements disposed in a vertical plane.

8. Process according to claim 1 to 7, characterised in that the binding metal is vaporised in the form of metastable hydrides.

9. Process according to claim 1 to 8, characterised in that WC-Co hard alloy is used as a substrate.

## Revendications

1. Procédé d'amélioration de l'adhérence entre un substrat en métal dur pour plaquettes de coupe, constitué d'un matériau dur et d'un métal liant, et une couche de diamant qui y est déposée à partir de la phase gazeuse au moyen d'un procédé de dépôt chimique en phase vapeur à filaments chauds (HF-CVD), dans lequel du métal liant est enlevé par traitement thermique préalablement à l'application de la couche, ce qui modifie la structure de la surface du métal dur et rend cette dernière rugueuse,
caractérisé
- en ce que des dispositifs sont utilisés, pour l'enlèvement du métal liant, de la façon dont ils sont adaptés pour le procédé HF-CVD en fonction de la disponibilité de gaz contenant du carbone et d'hydrogène dissociant sur le filament chaud,
- en ce que le rapport entre le H₂ gazeux et le ou les hydrocarbures gazeux dans l'espace de réaction du dispositif est modifié à une valeur de 10₂ à 10₃ et la température de recuit T des éléments de filament chaud est simultanément amenée à une valeur > 2100°C, pour l'enlèvement du métal liant, à la différence des conditions nécessaires pour le dépôt d'une couche de diamant,
- en ce que des conditions d'état dans lesquelles de l'hydrogène dissocié se recombine en H₂ selon une réaction fortement exothermique sont établies en présence d'hydrogène dissociant à la surface du substrat, et il en résulte sous l'effet de la chaleur une évaporation de métal liant à partir de la zone marginale proche de la surface du substrat,
- en ce que l'intérieur du substrat est réglé à des températures inférieures à une limite supérieure à partir de laquelle se produit intérieurement une modification de matière qui influence l'utilisation, conforme aux prescriptions, du substrat revêtu du diamant.

2. Procédé selon la revendication 1, caractérisé en ce que la surface de substrat à revêtir est amenée, pour l'évaporation de métal liant, à une distance D du plan des éléments de filaments chauds qui est plus petite que celle des conditions nécessaires pour le dépôt d'une couche de diamant.

3. Procédé selon la revendication 1 ou 2, caractérisé en ce que le gaz est amené dans l'espace de réaction sous une pression totale p de 0,1 à 25 kPa.

4. Procédé selon l'une quelconque des revendications 1 à 3, caractérisé en ce que le gaz de processus est amené sous une pression totale p de 0,1 à 25 kPa.

5. Procédé selon l'une quelconque des revendications 1 à 4, caractérisé en ce que l'enlèvement du métal liant s'effectue au cours d'une durée t de processus de 0,5 à 6 heures.

6. Procédé selon l'une quelconque des revendications 1 à 5, caractérisé en ce que les paramètres suivants de processus sont utilisés pour l'enlèvement du métal liant : T = 2250 à 2300°C, D = 2,5 à 3 mm, p = 1,3 à 2,0 kPa, t = 2,5 à 3 h.

7. Procédé selon l'une quelconque des revendications 1 à 6, caractérisé en ce que les substrats sont agencés sur les deux côtés d'éléments à filaments chauds agencés dans un plan vertical.

8. Procédé selon l'une quelconque des revendications 1 à 7, caractérisé en ce que le métal liant est évaporé sous forme d'hydrures métastables.

9. Procédé selon l'une quelconque des revendications 1 à 8, caractérisé en ce qu'un métal dur WC-Co est utilisé comme substrat.
